# EUROPEAN PATENT APPLICATION

(11) **EP 2 025 768 A1**
(43) Date of publication of application: **18.02.2009**
(21) Application number: 07254121.2
(22) Date of filing: 17.10.2007
(51) Int. Cl.: C22C 5/04, C22C 19/03, C22C 30/00, C22B 9/00, C22C 1/02, C22C 1/03, C22F 1/10, C22F 1/14, C23C 14/34

(54) **Ultra-high purity NiPt alloys and sputtering targets comprising same**

(30) Priority: 23.07.2007 US 880847
(71) Applicant: Heraeus, Inc., Chandler AZ 85226 (US)
(72) Inventor: Hui, Jun, Maricopa AZ 85239 (US); Li, ShinHwa, Chandler AZ 85248 (US); Long, David, Chandler AZ 85249 (US); Derrington, Carl, Tempe AZ 85284 (US); Kunkel, Bernd, Phoenix AZ 85048 (US)
(74) Representative: Driver, Virginia Rozanne

(57) **Abstract**

A method of making a NiPt alloy having an ultra-high purity of at least about 4N5 and suitable for use as a sputtering target, comprises steps of: heating predetermined amounts of lesser purity Ni and Pt at an elevated temperature in a crucible to form a NiPt alloy melt, the crucible being composed of a material which is inert to the melt at the elevated temperature; and transferring the melt to a mold having a cavity with a surface coated with a release agent which does not contaminate the melt with impurity elements. The resultant NiPt alloy has a very low concentration of impurity elements and is subjected to cross-directional hot rolling for reducing thickness and grain size.

## Description

### FIELD OF THE DISCLOSURE

The present disclosure relates generally to ultra-high purity NiPt alloys, their manufacturing methodology, and to sputtering targets comprising same. The ultra-high purity NiPt sputtering targets afforded by the present disclosure are especially useful in the manufacture of high integration density semiconductor devices.

### BACKGROUND OF THE DISCLOSURE

Development of new technologies for use in the semiconductor integrated circuit (IC) industry is driven by "Moore's Law", i.e., which postulates doubling of the areal density of transistors roughly every 18 months, with the resultant size reduction of electronic devices leading to lower cost with increased profitability, more functions, and faster device speeds. Currently, manufacturing technology is transitioning from 90 nm feature sizes, e.g., transistor gate length and pitch-to-pitch line width, to 65 nm and lower. The reduction in feature size necessitates development of new materials, e.g., semiconductors and materials used in transistor formation and processing.

Recently, there has been much interest in various approaches with the aim or goal of developing new semiconductor materials which provide increased speeds of electron and hole flow therethrough, thereby permitting fabrication of semiconductor devices, such as integrated circuit (IC) devices with higher operating speeds, enhanced performance characteristics, and lower power consumption. One such material which shows promise in attaining the goal of higher device operating speeds is termed "strained silicon".

According to this approach, a very thin, tensilely strained, crystalline silicon (Si) layer is grown on a relaxed, graded composition SiGe buffer layer several microns thick, which SiGe buffer layer in turn is formed on a suitable crystalline substrate, e.g., a Si wafer or a silicon-on-insulator (SOI) wafer. Strained Si technology is based upon the tendency of the Si atoms, when deposited on the SiGe buffer layer, to align with the greater lattice constant (spacing) of the Si and Ge atoms therein (relative to pure Si). As a consequence of the Si atoms being deposited on a substrate (SiGe) comprised of atoms which are spaced further apart, they "stretch" to align with the underlying Si and Ge atoms, thereby "stretching" or tensilely straining the deposited Si layer. Electrons and holes in such strained Si layers have greater mobility than in conventional, relaxed Si layers with smaller inter-atom spacings, i.e., there is less resistance to electron and/or hole flow. For example, electron flow in strained Si may be up to about 70 % faster compared to electron flow in conventional Si.

Transistor devices (e.g., CMOS devices) formed with such strained Si layers exhibit operating speeds which are substantially faster than those of equivalent devices formed with conventional Si. However, stable, low resistivity contact materials are not currently available for use with the strained lattice semiconductor material of the transistor source and drain regions. Specifically, Co-based and Ti-based silicides typically utilized as contacts with 90 nm (and above) feature sizes are not suitable for use with feature sizes of 65 nm and below.

As a consequence of the unsuitability of Co-based and Ti-based silicides, NiPt-silicide contact technology has been developed for use in fabricating transistors with feature sizes of 65 nm and below formed on strained lattice semiconductor substrates. However, currently available practices/technologies are incapable of providing the ultra-high purity NiPt alloy materials necessary for use as sputtering targets utilized for NiPt deposition in the manufacture of high performance, strained semiconductor IC devices with feature sizes of 65 nm and below.

Another recent approach for transitioning from 90 nm feature sizes to 65 nm and lower, e.g., 45 nm and lower, involves use of high k dielectric gate oxide materials and metal-silicide contact metallization, such as hafnium oxide-based high k dielectric materials and NiSi contact metallization. In this regard, NiSi offers several advantages vis-a-vis earlier metal silicides such as CoSi₂ and TiSi₂, including lower resistivities, reduced Si consumption during silicidation, and formation at lower process temperatures. A currently promising fabrication scheme utilizing NiSi, termed "FUSI" (short for "fully silicided" gate), involves performing source/drain ("S/D") silicidation prior to gate patterning and silicidation. However, the use of NiSi in FUSI and other high k gate oxide process schemes for feature size reduction poses challenges arising from poor thermal stability at process integration temperatures and high diffusivity.

In view of the foregoing, there exists a need for improved Ni-based materials suitable for use as silicided gate contact metallization in FUSI and other fabrication schemes for the next generation of semiconductor IC devices, as well as ultra-high purity NiPt alloy materials suitable for use as sputtering targets in the manufacture of high performance, strained semiconductor IC devices with feature sizes of 65 nm and below, and improved manufacturing technology therefor.

### SUMMARY OF THE DISCLOSURE

An advantage of the present disclosure is a method of making ultra- high purity NiPt alloys.

Another advantage of the present disclosure is ultra-high purity NiPt alloys.

Yet another advantage of the present invention is sputtering targets comprising ultra-high purity NiPt alloys with uniform grain size distribution.

Additional advantages and features of the present disclosure will be set forth in the disclosure which follows and in part will become apparent to those having ordinary skill in the art upon examination of the following or may be learned from the practice of the present disclosure. the advantages may be realized and obtained as particularly pointed out in the appended claims.

According to an aspect of the present disclosure, the foregoing and other advantages are achieved in part by an improved method of making a NiPt alloy having an ultra-high purity of at least about 4N5, comprising steps of:
(a) heating predetermined amounts of lesser purity Ni and Pt at an elevated temperature in a crucible to form a NiPt alloy melt, the crucible being composed of a material which is inert to the melt at the elevated temperature; and
(b) transferring the melt to a mold having a cavity with a surface coated with a release agent which does not contaminate the melt with impurity elements.

According to embodiments of the present disclosure, step (a) comprises heating at a temperature from about 1455 to about 1650 °C to form the NiPt alloy melt; heating predetermined amounts of lesser purity Ni and Pt in Ni : Pt atomic ratios ranging from about 99 : 1 to about 20 : 80; forming the melt by a process comprising vacuum induction melting (VIM) in a crucible composed of yttria stabilized zirconia (YSZ); and purifying the NiPt alloy melt by removing impurity-containing slag which forms at an upper surface of the melt and/or by evaporation of impurities from the melt.

In accordance with embodiments of the present disclosure, step (b) comprises directly transferring said melt to the mold without use of a tundish; the mold being composed of graphite and having a cavity coated with Al₂O₃ release agent.

According to embodiments of the present disclosure, the method further comprises steps of: (c) removing an ingot of solidified NiPt alloy from the mold; and (d) subjecting the ingot to thermo-mechanical rolling for reducing thickness and grain size of the NiPt alloy, wherein step (d) comprises alternate rolling in straight and cross directions and re-heating the NiPt alloy during the straight direction rolling.

Another aspect of the present disclosure is a 4N5 ultra-high purity NiPt alloy fabricated by the above process.

Still another aspect of the present disclosure is a 4N5 ultra-high purity NiPt alloy having a Si concentration of < 1 ppm, a B concentration of < 0.2 ppm, a Ca concentration of < 0.05 ppm, an Al concentration of < 0.1 ppm, and a total impurity concentration of < 50 ppm, wherein the Ni : Pt atomic ratio is in the range from about 99 : 1 to about 20 : 80, and the grain size ranges from about 200 to about 300 µm.

Yet another aspect of the present disclosure is an improved sputtering target comprising the above 4N5 ultra-high purity NiPt alloy.

Additional advantages of the present disclosure will become readily apparent to those skilled in this art from the following detailed description, wherein only the preferred embodiments of the present disclosure are shown and described, simply by way of illustration of the best mode contemplated for practicing the present disclosure. As will be realized, the disclosure is capable of other and different embodiments, and its several details are capable of modification in various obvious respects, all without departing from the spirit of the present disclosure. Accordingly, the drawings and description are to be regarded as illustrative in nature, and not as restrictive.

### BRIEF DESCRIPTION OF THE DRAWINGS

The following detailed description of the embodiments of the present disclosure can best be understood when read in conjunction with the following drawings, in which:

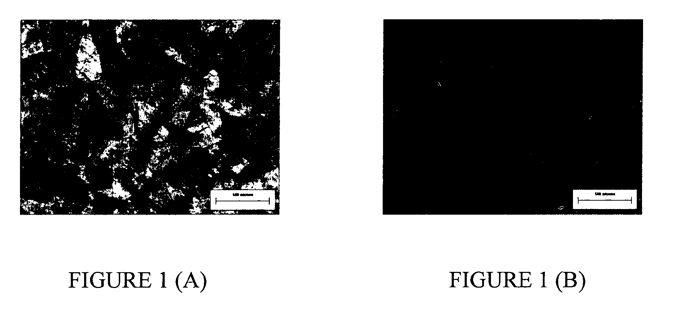

FIGS. 1 (A) and 1 (B) are photomicrographs respectively showing the grain structures of a straight-rolled NiPt alloy formed according to conventional (prior) practice with grain sizes in the 400 - 500 µm range and a cross-rolled NiPt alloy formed according to the present disclosure with grain sizes in the 200 - 300 µm range.

### DETAILED DESCRIPTION OF THE DISCLOSURE

The present disclosure addresses and overcomes the problems associated with the inability of currently available practices/technologies to provide the ultra-high purity NiPt alloy materials necessary for use as sputtering targets utilized in the manufacture of high performance semiconductor IC devices with feature sizes of 65 nm and below, including devices formed on strained semiconductor substrates and/or with gate structures comprising Ni-silicide contact metallization and high k gate oxides.

Briefly stated, according to key features of the present disclosure, ultra-high purity NiPt alloys (i.e. of 4N5 purity and higher), with Ni:Pt atomic ratios from about 99 : 1 to about 20 : 80, suitable for use in the fabrication of sputtering targets useful, inter alia, in the manufacture of the above-mentioned high performance semiconductor IC devices, are formed by a process comprising vacuum induction melting (VIM) of raw materials of lesser impurity (e.g., 3N Ni and 3N5 Pt), followed by casting/molding to form an ingot which is then subjected to thermo-mechanical processing, e.g., cross-directional hot rolling, to reduce the thickness and grain size, and provide a uniform grain size distribution across the surface of the ultimately formed sputtering target. According to the present disclosure, melting and casting/molding procedures are employed which avoid contamination resulting from the melting process. The resultant NiPt alloys have very low B and Si impurity levels, each well below that of the starting (raw) materials, as well as substantially reduced levels of a number of other impurity elements.

In more detail, it was determined/noted that quantities of B, Al, Si, Ca, and other elements were introduced into NiPt ingots formed by conventional processing methodology. Specifically, B was identified as arising from the BN release agent utilized with graphite molds, which BN can react with molten Ni. Consequently, according to the instant process methodology, an alternate release agent, e.g., Al₂O₃, is utilized to protect the graphite mold.

It was also determined/noted that the traces of Al, Ca, and Si found in the NiPt ingots formed by conventional processing methodology were derived from the Al₂O₃ crucible utilized for melting of the constituent raw material(s). Further, Al₂O₃-based crucibles, which are stable at melting temperatures below about 1600 °C, are not stable when subjected to the high temperatures utilized in forming molten NiPt, and consequently may shed particles of Al₂O₃ to the melt or emit particles of its bonding material (Si). Therefore, according to the instant process methodology for forming ultra-high purity NiPt alloys, a crucible formed of a material which is substantially inert to molten NiPt under the above temperature conditions utilized for forming the NiPt melt, e.g., yttria-stabilized zirconia (YSZ), is substituted for the conventional Al₂O₃-based crucible.

It was further determined/noted that another possible source of Al, Ca, and Si impurities/contaminants is the tundish conventionally employed for guiding a pour stream of molten NiPt from a crucible to a casting mold. According to the present disclosure, therefore, the necessity of a tundish is eliminated by selection/use of a mold cavity allowing for direct transfer of the NiPt melt from the crucible to the mold, thereby eliminating possible contamination from the tundish.

The ability of the presently disclosed methodology to provide ultra-high purity (e.g., 4N5) NiPt alloys with significantly reduced concentrations of Si, B, Ca, and Al, as well as significantly reduced total impurity levels and uniformly distributed fine grain sizes will now be demonstrated by reference to the following illustrative, but non-limitative, example of the presently disclosed methodology.

### Example

Square blocks of 3N5 purity Ni and 3N Pt shot in a Ni/Pt atomic ratio of 95 : 5 were placed in a YSZ crucible and subjected to vacuum induction melting (VIM) at a temperature of about 1600°C for about 1-1.5 hrs. to form a NiPt alloy melt. The melt was purified by pouring off any slag which formed on the top and/or by evaporation of impurities under the vacuum atmosphere. The melt was then poured, without the use of a tundish, into a graphite mold lined with an Al₂O₃ mold release agent and solidified into a NiPt alloy ingot.

Results of full element glow discharge mass spectroscopy ("GDMS") studies of targets comprised of NiPt alloys formed according to the conventional and present methodology are given in Table I below, wherein the column heading "Customer desired specification" refers to a specification of a semiconductor IC manufacturer for impurity levels of NiPt sputtering targets and the other column headings "Conventional (prior) process" and "Instant process" respectively designate impurity content of NiPt alloy sputtering targets fabricated according to conventional methodology as described above and according to the instantly disclosed methodology.

**Table I**

| Element | Customer desired specification, ppm | Conventional (prior) process, ppm | Instant process, ppm |
|---|---|---|---|
| Ag | < 0.1 | < 1 | < 0.1 |
| Al | < 0.5 | < 50 | < 0.1 |
| B | < 0.2 | < 100 | < 0.2 |
| C | < 50 | < 100 | < 0.2 |
| Ca | < 0.5 | < 10 | < 0.05 |
| Cl | < 0.5 | < 10 | < 0.05 |
| Co | < 3 | <50 | < 3 |
| Cr | < 1 | < 50 | < 1 |
| Cu | < 2 | < 50 | < 1 |
| Fe | < 6 | <50 | < 6 |
| H | <10 | <50 | <10 |
| Mg | < 5 | < 50 | < 0.1 |
| N | < 30 | < 50 | < 30 |
| O | < 50 | < 100 | < 100 |
| S | < 1 | < 50 | < 0.5 |
| Si | < 1 | < 200 | < 1 |
| Zn | <0.1 | < 50 | < 0.1 |
| Zr | < 20 | < 50 | < 1 |
| Total impurities, ppm | < 50 | < 1000 | < 50 |

It is apparent from the data of Table I that high concentrations of Si, B, Ca, and Al can be present in the conventionally fabricated sputtering targets, with total impurity levels exceeding 1000 ppm, and that the concentrations of Si, B, Ca, and Al of the ultra-high purity NiPt alloy formed by the presently disclosed methodology are significantly lower than those formed according to conventional practice, and in some instances are lower than required by customer specification. For example, the Si concentration is < 1 ppm, as compared with < 200 ppm in the conventionally prepared NiPt alloy, and comparable to the customer specification of < 1 ppm; the B concentration is < 0.2 ppm, as compared with < 100 ppm in the conventionally prepared alloy, and comparable to the customer specification of < 0.2 ppm; the Ca concentration is < 0.05 ppm, as compared with < 10 ppm in the conventionally prepared alloy, and better than the customer specification of < 0.5 ppm; and the Al concentration is < 0.1 ppm, as compared with < 50 ppm in the conventionally prepared alloy, and better than the customer specification of < 0.5 ppm.

The total impurity concentration of the NiPt alloy produced by the present process is < 50 ppm, comparable to the customer desired specification value, and substantially lower than the < 1000 ppm of NiPt alloys produced by the conventional (prior) methodology. The present methodology thereby meets a requirement for 4N5 ultra-high purity NiPt alloys for use in fabricating sputtering targets suitable for high performance semiconductor IC device manufacture.

The resultant ultra-high purity NiPt ingot was then subjected to a more aggressive thermo-mechanical roll schedule than is conventional, in order to achieve a greater reduction in thickness and grain size, with a more uniform distribution of grain size than provided by prior methodologies, which aggressive roll schedule comprises alternate rolling in straight and cross directions, with re-heating during the straight direction rolling. In contrast with prior hot rolling processes involving straight direction rolling, which can provide a total thickness reduction of about 60 % at temperatures in the range 2000 - 3000 °F, the cross-directional rolling according to the present methodology provides a total thickness reduction of about 75 % at comparable temperatures in the range 2000 - 3000°F.

The increased thickness reduction afforded by the instant methodology forces more grains to experience dynamic recrystallization at the elevated deformation temperature. Photomicrographs, as shown in FIGS. 1 (A) and 1 (B), indicate that the grain sizes are reduced from the 400 - 500 µm range when hot rolling is performed according to the prior straight direction rolling process to the 200 - 300 µm range when hot rolling is performed according to the cross-direction rolling process. In addition, grain sizes are more uniformly distributed across the surface of the rolled plate when hot rolling is performed according to the cross-direction rolling process, and the Vicker's hardness for NiPt alloys formed according to the present methodology is greater than that for NiPt alloys produced according to the conventional methodology. For example, for Ni-5at. % Pt alloys, the Vicker's hardness Hᵥ for alloys formed by the present methodology is in the range 150 - 370, whereas the Vicker's hardness Hᵥ for alloys formed by the conventional methodology is in the range 100 - 370.

The resultant rolled plates formed by the cross-directional hot rolling process can be cut to a desired size and mounted, in conventional fashion, to a backing plate for use as a sputtering target.

In summary, notable advantages afforded by the process methodology according to the present disclosure vis-à-vis conventional technology for forming NiPt alloys and sputtering targets include:
1. substantially reduced levels of Si, B, Ca, and Al;
2. total impurity levels well within the requirements for meeting 4N5 ultra-high purity;
3. reduced grain size with uniform grain size distribution;
4. increased Vicker's hardness;
5. ability to melt/cast lower grades of Ni and Pt into ultra-high purity NiPt alloys; and
6. readily practiced melting/casting process methodology not requiring special equipment or capital investment, which melting/casting process is significantly less costly than powder metallurgy processing, particularly for alloys with high Pt content.

In the previous description, numerous specific details are set forth, such as specific materials, structures, reactants, processes, etc., in order to provide a better understanding of the present disclosure. However, the present disclosure can be practiced without resorting to the details specifically set forth. In other instances, well-known processing materials and techniques have not been described in detail in order not to unnecessarily obscure the present disclosure.

Only the preferred embodiments of the present disclosure and but a few examples of its versatility are shown and described in the present disclosure. It is to be understood that the present disclosure is capable of use in various other combinations and environments and is susceptible of changes and/or modifications within the scope of the disclosed concept as expressed herein.

## Claims

1. A method of making an ultra-high purity NiPt alloy of at least 4N5 purity, comprising steps of:
(a) heating predetermined amounts of lesser purity Ni and Pt at an elevated temperature in a crucible to form a NiPt alloy melt, said crucible being composed of a material which is inert to said melt at said elevated temperature; and
(b) transferring said melt to a mold having a cavity with a surface coated with a release agent which does not contaminate said melt with impurity elements.

2. The method according to claim 1, wherein:
step (a) comprises heating at a temperature from about 1455 to about 1650 °C to form said NiPt alloy melt.

3. The method according to claim 1, wherein:
step (a) comprises heating predetermined amounts of lesser purity Ni and Pt in Ni : Pt atomic ratios ranging from about 99 : 1 to about 20 : 80.

4. The method according to claim 1, wherein:
step (a) comprises vacuum induction melting (VIM).

5. The method according to claim 1, wherein:
step (a) comprises forming said NiPt alloy melt in a crucible composed of yttria stabilized zirconia (YSZ).

6. The method according to claim 1, wherein:
step (a) comprises purifying said NiPt alloy melt by removing impurity-containing slag which forms at an upper surface of said melt.

7. The method according to claim 1, wherein:
step (a) comprises purifying said NiPt alloy melt by evaporation of impurities from said melt.

8. The method according to claim 1, wherein:
step (b) comprises directly transferring said melt to said mold without use of a tundish.

9. The method according to claim 1, wherein:
step (b) comprises directly transferring said NiPt alloy melt to a mold composed of graphite and having a cavity coated with Al₂O₃ release agent.

10. The method according to claim 1, further comprising steps of:
(c) removing an ingot of solidified NiPt alloy from said mold; and
(d) subjecting said ingot to thermo-mechanical rolling for reducing thickness and grain size of said NiPt alloy.

11. The method according to claim 10, wherein:
step (d) comprises alternate rolling in straight and cross directions.

12. The method according to claim 11, wherein:
step (d) comprises re-heating said NiPt alloy during said straight direction rolling.

13. A 4N5 ultra-high purity NiPt alloy fabricated by the process according to claim 12.

14. A 4N5 ultra-high purity NiPt alloy having a Si concentration of < 1 ppm, a B concentration of < 0.2 ppm, a Ca concentration of < 0.05 ppm, an Al concentration of < 0.1 ppm, and a total impurity concentration of < 50 ppm.

15. The NiPt alloy as in claim 14, having a Ni : Pt atomic ratio in the range from about 99 : 1 to about 20 : 80.

16. The NiPt alloy as in claim 14, having with a grain size from about 200 to about 300 µm.

17. A sputtering target comprising the 4N5 ultra-high purity NiPt alloy of claim 16.
